# EUROPEAN PATENT APPLICATION

(11) **EP 3 343 563 A1**
(43) Date of publication of application: **04.07.2018**
(21) Application number: 17207171.4
(22) Date of filing: 13.12.2017
(51) Int. Cl.: G11C 7/10

(54) **MATRIX STORAGE USING DATA SHIFTING MEMORY**

(30) Priority: 30.12.2016 US 201615395427
(71) Applicant: INTEL Corporation, Santa Clara, CA 95054 (US)
(72) Inventor: YANG, Andrew, Cupertino, CA California 95014 (US); KLOSS, Carey K., Los Altos, CA California 94022 (US); WERNER, Tony L., Los Altos, CA California 94022 (US); LAU, Horace, Mountain View, CA California 94043 (US)
(74) Representative: Samson & Partner Patentanwälte mbB

(57) **Abstract**

In one embodiment, an apparatus comprises a memory and a memory controller. The memory comprises a plurality of memory modules, wherein each memory module comprises a plurality of storage locations. The memory controller may be configured to write data of a matrix to the memory. For example, the memory controller may be configured to write a particular row or a particular column of the matrix to the memory by: shifting a plurality of matrix elements of the particular row or the particular column; and writing the plurality of matrix elements to the plurality of memory modules.

## Description

### FIELD OF THE SPECIFICATION

This disclosure relates in general to the field of computer processing, and more particularly, though not exclusively, to efficient storage of matrix data.

### BACKGROUND

Matrix operations (e.g., transpose operations, matrix multiplication, convolutions) can be highly memory-intensive and processor-intensive operations, as they often involve complex operations on large, multi-dimensional matrix operands. Accordingly, the performance of complex matrix operations can be limited by memory and/or processing latency. As matrix operations are increasingly utilized in a variety of applications and with ever-growing data sets (from graphics and image processing to machine learning and artificial intelligence), the demand for high-performance processing of matrix operations is increasing.

### BRIEF DESCRIPTION OF THE DRAWINGS

The present disclosure is best understood from the following detailed description when read with the accompanying figures. It is emphasized that, in accordance with the standard practice in the industry, various features are not necessarily drawn to scale, and are used for illustration purposes only. Where a scale is shown, explicitly or implicitly, it provides only one illustrative example. In other embodiments, the dimensions of the various features may be arbitrarily increased or reduced for clarity of discussion.
**FIGURE 1** illustrates a schematic diagram for an example computing system according to certain embodiments.
**FIGURES 2A-C** illustrate block diagrams for an example embodiment of a matrix processing architecture.
**FIGURES 3** **and** **4** illustrate block diagrams for example embodiments of computer processors.
**FIGURE 5** illustrates an example embodiment of memory for storing matrices using data shifting.
**FIGURE 6** illustrates another example embodiment of memory for storing matrices using data shifting.
**FIGURE 7** illustrates a flowchart for an example embodiment of matrix storage using data shifting memory.

### EMBODIMENTS OF THE DISCLOSURE

The following disclosure provides many different embodiments, or examples, for implementing different features of the present disclosure. Specific examples of components and arrangements are described below to simplify the present disclosure. These are, of course, merely examples and are not intended to be limiting. Further, the present disclosure may repeat reference numerals and/or letters in the various examples. This repetition is for the purpose of simplicity and clarity and does not in itself dictate a relationship between the various embodiments and/or configurations discussed. Different embodiments may have different advantages, and no particular advantage is necessarily required of any embodiment.

Matrix processing operations (e.g., linear algebra operations that involve matrix and/or vector operands) have a wide range of applications in computing systems, from graphics processing to machine learning and artificial intelligence, among other examples. For example, complex matrix operations may be used to implement artificial neural networks that provide artificial intelligence and machine learning capabilities, including computer vision, autonomous navigation, speech and audio recognition, and natural language processing, among other examples. These complex matrix operations (e.g., transpose operations, matrix multiplication, and convolutions) may be used to implement the fundamental operations of neural networks, such as forward propagation, backward propagation, and weight updates. These matrix operations, however, can be highly processor and memory intensive, as they often involve complex operations on large, multi-dimensional matrix operands. Accordingly, the performance of these matrix operations can be limited by memory and/or processing latency. As matrix operations are increasingly utilized in a variety of applications with ever-growing data sets, such as artificial intelligence and machine learning, the demand for both high-performance processing of matrix operations is increasing.

Existing matrix processing approaches suffer from various inefficiencies, particularly when used to implement artificial intelligence and machine learning in artificial neural networks. For example, many matrix memory and storage approaches are inefficient for complex operations on large matrix operands, and thus may result in high memory latency, which can significantly reduce performance. For example, matrices can be stored in memory using a variety of approaches. Some approaches for storing matrices are inefficient, however, as they are unable to efficiently access both rows and columns of a matrix. For example, some approaches are unable to access particular rows and columns of a matrix in their entirety, instead requiring each element of a particular row or column to be accessed individually (e.g., by accessing each element in separate clock cycles). Moreover, some approaches are only able to access either the rows of a matrix or the columns of a matrix in their entirety, but not both. For example, some approaches can access particular rows of a matrix in their entirety, while particular columns can only be accessed by separately accessing each element. Similarly, some approaches can access particular columns of a matrix in their entirety, while particular rows can only be accessed by separately accessing each element. Accordingly, these matrix memory and storage approaches are inefficient for matrix operations that involve access to entire rows and columns of a matrix. For example, a transpose operation is a common operation used in many complex matrix algorithms. A transpose operation, for example, is used to "transpose" the rows and columns of a matrix, by rearranging the rows as columns and the columns as rows. A transpose operation can be performed on a matrix processor, for example, by retrieving each row of a matrix from memory, and then storing each row back in memory as a column. Accordingly, a transpose operation may be very inefficient if the underlying memory is unable to store and retrieve rows and columns of a matrix in their entirety, as it may involve a significant number of memory accesses.

The matrix memory and storage embodiments described throughout this disclosure provide an efficient approach for accessing both rows and columns of a matrix stored in memory. In some cases, for example, embodiments of this disclosure may be used to store or retrieve an entire row or column of a matrix (or a portion of the matrix) in a single clock cycle. For example, in some embodiments, a memory for storing matrix data of size N x M (e.g., N rows of matrix data and M columns of matrix data) can be implemented using M separate memory components that are each N entries deep. Moreover, the elements of each particular row and column of a matrix (or a portion of the matrix) are spread or shifted across the M separate memory components of the memory. In this manner, each element of a particular row or column is stored in a different memory component. Accordingly, a particular row or column of the matrix (or a portion of the matrix) can be accessed in its entirety by accessing the appropriate entry of each of the M separate memory components. In this manner, an entire row or column of a matrix stored in memory can be accessed in a single clock cycle.

The matrix memory and storage embodiments described throughout this disclosure provide numerous technical advantages, including alleviating the inefficiencies of existing matrix memory and storage approaches, and enabling fast access to both rows and columns of matrices stored in memory. These advantages result in reduced memory latency and reduced processing time for matrix operations, thus improving the performance of systems and applications that involve complex matrix operations, such as those used to implement artificial intelligence and machine learning functionality in artificial neural networks (e.g., convolutional neural networks, multilayer perceptrons (MLPs), restricted Boltzmann machines (RBM), and deep belief networks (DBN), among other examples).

Example embodiments that may be used to implement the matrix processing functionality of this disclosure will now be described with more particular reference to the attached FIGURES.

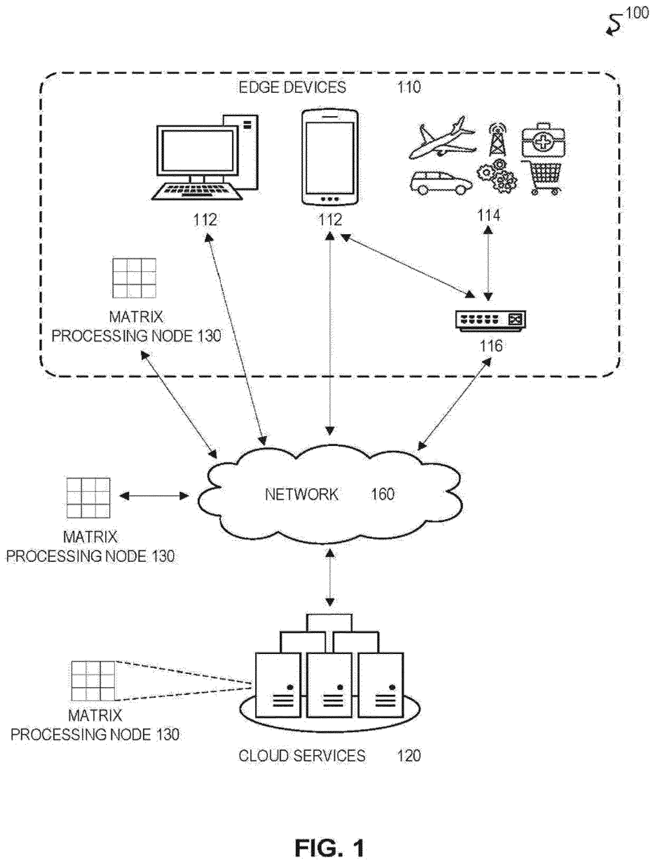

**FIGURE 1** illustrates a schematic diagram for an example computing system 100 according to certain embodiments.

In some embodiments, the matrix processing functionality described throughout this disclosure may be implemented in system 100. Matrix processing functionality may be used in system 100 for a wide range of applications and/or use cases involving matrix operations, from graphics processing to machine learning and artificial intelligence, among other examples. For example, in some embodiments, matrix processing functionality may be used to implement artificial intelligence and machine learning in artificial neural networks. Moreover, matrix processing functionality may be implemented by any component of system 100. For example, in the illustrated embodiment, system 100 includes edge devices 110, cloud services 120, matrix processing nodes 130, and network 150. Matrix processing nodes 130 may include any component or device with matrix processing functionality, including any component of system 100. For example, matrix processing nodes 130 may include cloud services 120 and/or servers implemented with matrix processing functionality (e.g., application servers in a datacenter), edge devices 110 implemented with matrix processing functionality (e.g., end-user devices 112, Internet-of-Things devices 114, gateways 116), and so forth. These various components of system 100 are discussed further below.

Edge devices 110 may include any equipment and/or devices deployed or connected near the "edge" of a communication system 100. Edge devices 110 may communicate with each other and/or with other remote networks and services (e.g., cloud services 120) through one or more networks and/or communication protocols, such as network 150. In some embodiments, certain edge devices 110 may include the matrix processing functionality described throughout this disclosure, and thus may be used as matrix processing nodes 130. In the illustrated embodiment, edge devices 110 include end-user devices 112 (e.g., desktops, laptops, mobile devices), Internet-of-Things (IoT) devices 114, and gateways and/or routers 116, among other examples.

End-user devices 112 may include any device that enables or facilitates user interaction with computing system 100, including, for example, desktop computers, laptops, tablets, mobile phones and other mobile devices, and wearable devices (e.g., smart watches, smart glasses, headsets), among other examples.

IoT devices 114 may include any device capable of communicating and/or participating in an Internet-of-Things (IoT) system or network. IoT systems may refer to new or improved ad-hoc systems and networks composed of multiple different devices (e.g., IoT devices 114) interoperating and synergizing for a particular application or use case. Such ad-hoc systems are emerging as more and more products and equipment evolve to become "smart," meaning they are controlled or monitored by computer processors and are capable of communicating with other devices. For example, an IoT device 114 may include a computer processor and/or communication interface to allow interoperation with other components of system 100, such as with cloud services 120 and/or other edge devices 110. IoT devices 114 may be "greenfield" devices that are developed with IoT capabilities from the ground-up, or "brownfield" devices that are created by integrating IoT capabilities into existing legacy devices that were initially developed without IoT capabilities. For example, in some cases, IoT devices 114 may be built from sensors and communication modules integrated in or attached to "things," such as equipment, toys, tools, vehicles, living things (e.g., plants, animals, humans), and so forth. Alternatively, or additionally, certain IoT devices 114 may rely on intermediary components, such as edge gateways or routers 116, to communicate with the various components of system 100.

IoT devices 114 may include various types of sensors for monitoring, detecting, measuring, and generating sensor data and signals associated with characteristics of their environment. For instance, a given sensor may be configured to detect one or more respective characteristics, such as movement, weight, physical contact, temperature, wind, noise, light, position, humidity, radiation, liquid, specific chemical compounds, battery life, wireless signals, computer communications, and bandwidth, among other examples. Sensors can include physical sensors (e.g., physical monitoring components) and virtual sensors (e.g., software-based monitoring components). IoT devices 114 may also include actuators to perform various actions in their respective environments. For example, an actuator may be used to selectively activate certain functionality, such as toggling the power or operation of a security system (e.g., alarm, camera, locks) or household appliance (e.g., audio system, lighting, HVAC appliances, garage doors), among other examples.

Indeed, this disclosure contemplates use of a potentially limitless universe of IoT devices 114 and associated sensors/actuators. IoT devices 114 may include, for example, any type of equipment and/or devices associated with any type of system 100 and/or industry, including transportation (e.g., automobile, airlines), industrial manufacturing, energy (e.g., power plants), telecommunications (e.g., Internet, cellular, and television service providers), medical (e.g., healthcare, pharmaceutical), food processing, and/or retail industries, among others. In the transportation industry, for example, IoT devices 114 may include equipment and devices associated with aircrafts, automobiles, or vessels, such as navigation systems, autonomous flight or driving systems, traffic sensors and controllers, and/or any internal mechanical or electrical components that are monitored by sensors (e.g., engines). IoT devices 114 may also include equipment, devices, and/or infrastructure associated with industrial manufacturing and production, shipping (e.g., cargo tracking), communications networks (e.g., gateways, routers, servers, cellular towers), server farms, electrical power plants, wind farms, oil and gas pipelines, water treatment and distribution, wastewater collection and treatment, and weather monitoring (e.g., temperature, wind, and humidity sensors), among other examples. IoT devices 114 may also include, for example, any type of "smart" device or system, such as smart entertainment systems (e.g., televisions, audio systems, videogame systems), smart household or office appliances (e.g., heat-ventilation-air-conditioning (HVAC) appliances, refrigerators, washers and dryers, coffee brewers), power control systems (e.g., automatic electricity, light, and HVAC controls), security systems (e.g., alarms, locks, cameras, motion detectors, fingerprint scanners, facial recognition systems), and other home automation systems, among other examples. IoT devices 114 can be statically located, such as mounted on a building, wall, floor, ground, lamppost, sign, water tower, or any other fixed or static structure. IoT devices 114 can also be mobile, such as devices in vehicles or aircrafts, drones, packages (e.g., for tracking cargo), mobile devices, and wearable devices, among other examples. Moreover, an IoT device 114 can also be any type of edge device 110, including end-user devices 112 and edge gateways and routers 116.

Edge gateways and/or routers 116 may be used to facilitate communication to and from edge devices 110. For example, gateways 116 may provide communication capabilities to existing legacy devices that were initially developed without any such capabilities (e.g., "brownfield" IoT devices). Gateways 116 can also be utilized to extend the geographical reach of edge devices 110 with short-range, proprietary, or otherwise limited communication capabilities, such as IoT devices 114 with Bluetooth or ZigBee communication capabilities. For example, gateways 116 can serve as intermediaries between IoT devices 114 and remote networks or services, by providing a front-haul to the IoT devices 114 using their native communication capabilities (e.g., Bluetooth, ZigBee), and providing a back-haul to other networks 150 and/or cloud services 120 using another wired or wireless communication medium (e.g., Ethernet, Wi-Fi, cellular). In some embodiments, a gateway 116 may be implemented by a dedicated gateway device, or by a general purpose device, such as another IoT device 114, end-user device 112, or other type of edge device 110.

In some instances, gateways 116 may also implement certain network management and/or application functionality (e.g., IoT management and/or IoT application functionality for IoT devices 114), either separately or in conjunction with other components, such as cloud services 120 and/or other edge devices 110. For example, in some embodiments, configuration parameters and/or application logic may be pushed or pulled to or from a gateway device 116, allowing IoT devices 114 (or other edge devices 110) within range or proximity of the gateway 116 to be configured for a particular IoT application or use case.

Cloud services 120 may include services that are hosted remotely over a network 150, or in the "cloud." In some embodiments, for example, cloud services 120 may be remotely hosted on servers in datacenter (e.g., application servers or database servers). Cloud services 120 may include any services that can be utilized by or for edge devices 110, including but not limited to, data storage, computational services (e.g., data analytics, searching, diagnostics and fault management), security services (e.g., surveillance, alarms, user authentication), mapping and navigation, geolocation services, network or infrastructure management, IoT application and management services, payment processing, audio and video streaming, messaging, social networking, news, and weather, among other examples. In some embodiments, certain cloud services 120 may include the matrix processing functionality described throughout this disclosure, and thus may be used as matrix processing nodes 130.

In general, edge devices 110 (and in particular IoT devices 114) may generate an extremely large volume and variety of data. IoT edge devices 114 typically offload this data to the cloud for processing and/or storage (e.g., by cloud services 120). Cloud services 120, however, may not necessarily be suited to handle the rapidly growing volume, variety, and velocity of data generated by IoT devices 114 and other edge devices 110. For example, cloud-based processing may not be ideal in certain circumstances, such as processing time-sensitive or highly confidential data, or when faced with network bandwidth constraints, among other examples. In some embodiments, cloud services 120 may leverage "edge" based processing using edge devices 110 to improve the performance of cloud services. Edge processing is an approach that involves processing certain data at the network edge (e.g., using edge devices 110), near where the data is generated, rather than simply funneling large volumes of data to the cloud for processing and storage. Certain data may still be sent to the cloud, as appropriate, such as for deeper analysis and/or long-term storage. Edge processing may be used to complement the shortcomings of cloud-based processing (e.g., when cloud-based processing is inefficient, ineffective, and/or unsecure), and thus improve the handling of the growing volume, variety, and velocity of data generated by IoT devices 114 and/or other edge devices 110. For example, in some cases, processing data near its source (e.g., in the network edge) rather than in the cloud may improve performance and/or avoid system failures or disasters. Edge processing may also conserve network bandwidth, which may be particularly beneficial when facing bandwidth constraints and/or limited network connectivity.

In some embodiments, edge devices 110 that provide edge-based processing for cloud services 120 may be collectively referred to as the "fog," as they serve to extend the "cloud" to the edge of the network, thus creating a "fog" over the network edge. In some embodiments, devices 110 in the "fog" may connect and/or communicate with each other, for example, using an interconnection standard or protocol. For example, in some embodiments, device interconnection may be implemented using the open interconnect consortium (OIC) standard specification 1.0, released by the Open Connectivity Foundation™ (OCF) on December 23, 2015, which enables devices to discover and connect with each other. Another interconnection protocol that may be used is Thread, a networking protocol for Internet-of-Things (IoT) devices used in "smart" home automation and similar deployments, which has been developed by an alliance of organizations named the "Thread Group." Other interconnection protocols may also be used, including, for example, the optimized link state routing (OLSR) protocol, or the better approach to mobile ad-hoc networking (B.A.T.M.A.N.), among others.

Network 150 may be used to facilitate communication between the components of computing system 100. For example, edge devices 110, such as end-user devices 112 and IoT devices 114, may use network 150 to communicate with each other and/or access one or more remote cloud services 120. Network 150 may include any number or type of communication networks, including, for example, local area networks, wide area networks, public networks, the Internet, cellular networks, Wi-Fi networks, short-range networks (e.g., Bluetooth or ZigBee), and/or any other wired or wireless networks or communication mediums.

Any, all, or some of the computing devices of system 100 may be adapted to execute any operating system, including Linux or other UNIX-based operating systems, Microsoft Windows, Windows Server, MacOS, Apple iOS, Google Android, or any customized and/or proprietary operating system, along with virtual machines adapted to virtualize execution of a particular operating system.

While FIGURE 1 is described as containing or being associated with a plurality of elements, not all elements illustrated within system 100 of FIGURE 1 may be utilized in each alternative implementation of the present disclosure. Additionally, one or more of the elements described in connection with the examples of FIGURE 1 may be located external to system 100, while in other instances, certain elements may be included within or as a portion of one or more of the other described elements, as well as other elements not described in the illustrated implementation. Further, certain elements illustrated in FIGURE 1 may be combined with other components, as well as used for alternative or additional purposes in addition to those purposes described herein.

### Example Matrix Processing Architecture

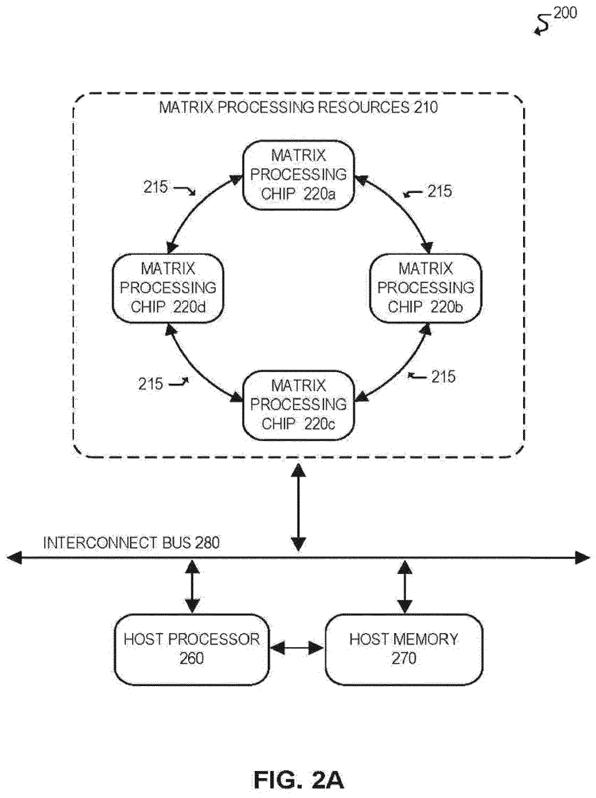

**FIGURES 2A-C** illustrate block diagrams for an example embodiment of a matrix processing architecture.

In some embodiments, the matrix processing functionality described throughout this disclosure may be implemented using a matrix processing architecture, such as the matrix processing architecture of FIGURES 2A - 2C. Matrix processing architectures, such as the matrix processing architecture of FIGURES 2A - 2C, may be implemented or used in a variety of systems, devices, and/or components, such as those described throughout this disclosure, including system 100 of FIGURE 1 and/or any of its associated components (e.g., cloud services 120 / datacenter servers, edge devices 110, matrix processing nodes 130). In some embodiments, the matrix processing architecture of FIGURES 2A - 2C may be used to implement artificial intelligence and machine learning in neural networks. The matrix processing architecture illustrated in FIGURES 2A - 2C is merely one example embodiment for performing the matrix processing functionality described throughout this disclosure. Other embodiments may use different types, arrangements, and/or numbers of components. For example, other embodiments may include any number of matrix processing chips 220, matrix processing clusters 230, matrix processing units (MPUs) 234, high bandwidth memory (HBM) modules 240, and/or memory resource blocks (MRBs) 238. Moreover, all or part of any component of the matrix processing architecture of FIGURES 2A - 2C (e.g., any component of matrix processing system 200, matrix processing chips 220, and/or matrix processing clusters 230) may be implemented as a separate or stand-alone component or chip, or may be integrated with other components or chips, such as a system-on-a-chip (SoC) that integrates various computer components into a single chip.

**FIGURE 2A** illustrates a block diagram for an example embodiment of a matrix processing system 200. In the illustrated embodiment, matrix processing system 200 includes host processor 260, host memory 270, matrix processing resources 210, and interconnect bus 280.

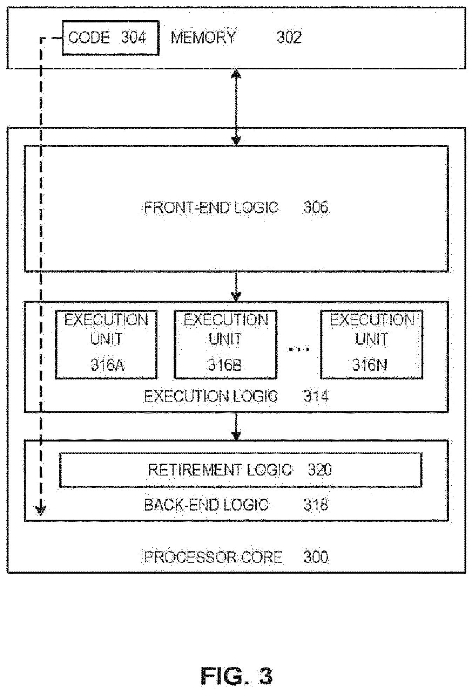

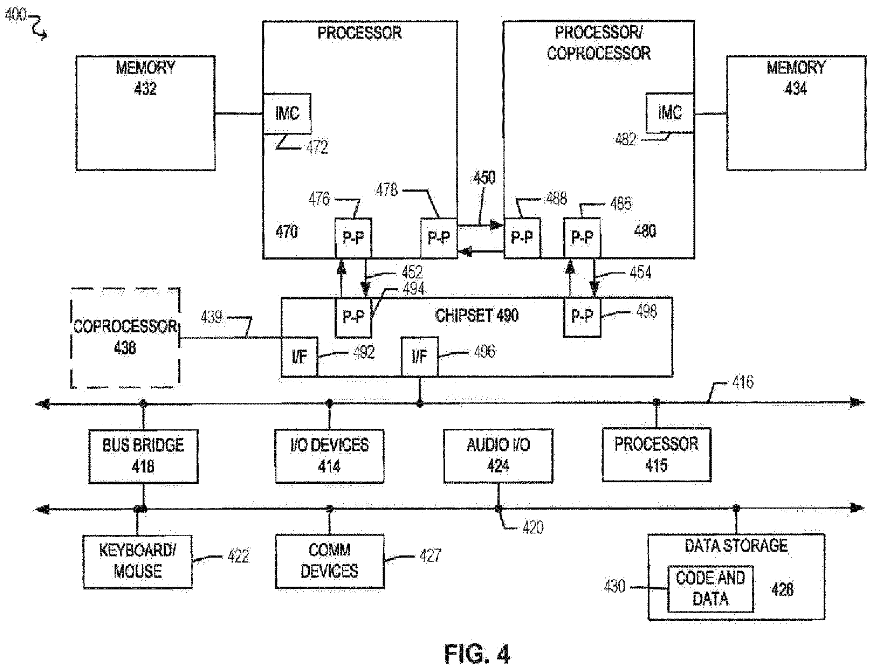

Host processor 260 may be configured to control and/or manage matrix processing system 200. For example, in some embodiments, host processor 260 may use matrix processing resources 210 to perform complex matrix operations. Host processor 260 may be any processing resource capable of controlling and/or managing matrix processing functionality of matrix processing system 200. For example, in some embodiments, host processor 260 may be implemented using computer processors 300 or 400 of FIGURES 3 and 4, respectively. In some embodiments, host processor 260 may be a separate or stand-alone component that is communicatively coupled to matrix processing resources 210. Alternatively, in other embodiments, host processor 260 and matrix processing resources 210 may be integrated into the same component or chip. For example, in some embodiments, the components of matrix processing system 200, including host processor 260 and matrix processing resources 210, may be implemented as a system-on-a-chip (SoC).

Host memory 270 may include any type or combination of volatile and/or non-volatile memory. Examples of volatile memory include various types of random access memory (RAM), such as dynamic random access memory (DRAM), synchronous dynamic random access memory (SDRAM), and static random access memory (SRAM), among other examples. Examples of non-volatile memory include disk-based storage mediums (e.g., magnetic and/or optical storage mediums), solid-state storage (e.g., any form of persistent flash memory, including planar or three dimensional (3D) NAND flash memory or NOR flash memory), 3D crosspoint memory, electrically erasable programmable read-only memory (EEPROM), and/or other types of non-volatile random access memories (RAM), among other examples. Host memory 270 may be used, for example, to store information for host processor 260 during execution, such as code and/or data.

Interconnect bus 280 may be used, in some embodiments, to communicatively couple host processor 260 and host memory 270 to matrix processing resources 210. Interconnect bus 280 may use any interconnection protocol, such as Peripheral Component Interconnect express (PCIe), Universal Serial Bus (USB), or Small Computer Systems Interface (SCSI), among other examples.

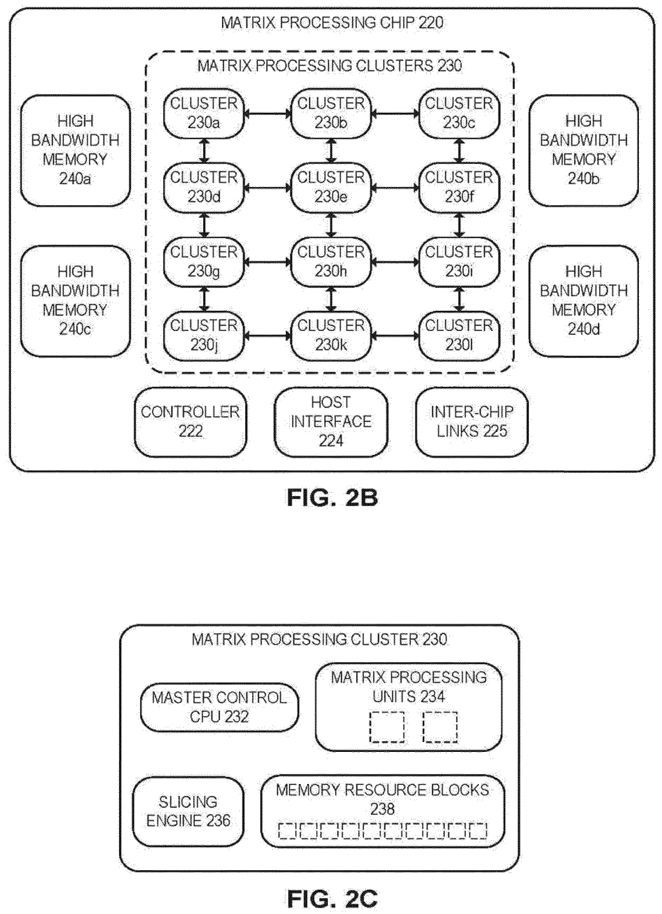

Matrix processing resources 210 may include any processing resources configured to perform matrix operations. For example, matrix processing resources 210 may be configured to perform matrix multiplication operations, convolution operations, element-wise matrix operations (e.g., +, *, / <, >, ==), dimension shuffle operations, and/or any combination thereof. In some embodiments, matrix processing resources 210 may include processing resources that are designed and optimized for performing matrix operations. In some embodiments, matrix processing resources 210 may also be arranged hierarchically with multiple levels of processing resources. For example, in the illustrated embodiment, matrix processing resources 210 include a plurality of matrix processing chips 220, and may also include any processing resources within each matrix processing chip 220. For example, as discussed below in connection with FIGURES 2B and 2C, each matrix processing chip 220 may include a plurality of high bandwidth memory (HBM) modules 240 and a plurality of matrix processing clusters 230, and each matrix processing cluster 230 may include multiple matrix processing units 234. Thus, in some embodiments, matrix processing resources 210 may include multiple matrix processing chips 220, multiple high bandwidth memory (HBM) modules 240 and multiple matrix processing clusters 230 on each matrix processing chip 220, and/or multiple matrix processing units 234 on each matrix processing cluster 230.

Matrix processing chips 220 may be, for example, any chips or other components configured to perform matrix operations. For example, in some embodiments, a matrix processing chip 220 may be a peripheral card or chip connected to host processor 260 using any type of interconnect interface, such as a PCIe interface. In some embodiments, a matrix processing chip 220 may be implemented using an integrated circuit, such as an application specific integrated circuit (ASIC), a field programmable gate array (FPGA), and/or any other type of circuitry. In the illustrated embodiment, matrix processing chips 220 are configured in a cyclical arrangement, with communication channels 215 between neighboring matrix processing chips 220. In some embodiments, communication channels 215 may provide one-way communication between neighboring matrix processing chips 220. In other embodiments, however, communication channels 215 may provide bi-directional communication between neighboring matrix processing chips 220. A cyclical arrangement with one-way communication between neighboring processing resources may be referred to as a "single-cyclical" configuration, while a cyclical arrangement with bi-directional communication between neighboring processing resources may be referred to as a "dual-cyclical" configuration.

Moreover, although not illustrated, in some embodiments matrix processing system 200 may include a communication interface to communicate over a communication network. For example, in some embodiments, matrix processing system 200 may communicate over a network with one or more remote matrix processing chips to perform distributed matrix operations.

**FIGURE 2B** illustrates a block diagram for an example embodiment of a matrix processing chip 220. In the illustrated embodiment, matrix processing chip 220 includes controller 222, host interface 224, inter-chip links 225, high bandwidth memory (HBM) modules 240, and matrix processing clusters 230.

Controller 222 may be configured to control and/or manage matrix operations performed by matrix processing chip 220. In some embodiments, controller 222 may control and/or manage matrix operations in conjunction with host processor 260 of FIGURE 2A and/or master control CPUs (MCCs) 232 of matrix processing clusters 230 of FIGURE 2C. For example, in some embodiments, host processor 260, controller 222, and/or master control CPUs (MCCs) 232 may be configured to receive a matrix operation or command, and distribute the matrix operation and matrix operands across matrix processing clusters 230 and high bandwidth memory (HBM) modules 240. In some embodiments, controller 222 may be a microprocessor, an integrated circuit, and/or any other type of circuitry and/or processing logic.

Host interface 224 may be a communication interface that enables a matrix processing chip 220 to communicate with host processor 260 of FIGURE 2A. In some embodiments, for example, controller 222 may use host interface 224 to communicate with host processor 260 of FIGURE 2A. Host interface 224 may use any type of interconnect protocol or interface, including Peripheral Component Interconnect express (PCIe), Universal Serial Bus (USB), or Small Computer Systems Interface (SCSI), among other examples.

Inter-chip links (ICLs) 225 may enable a matrix processing chip 220 to communicate with other matrix processing chips. For example, inter-chip links 225 may be used to implement the communication channels 215 between matrix processing chips 220 in FIGURE 2A. An inter-chip link 225 may be, for example, any communication interface that enables a matrix processing chip 220 to communicate with another matrix processing chip. In some embodiments, a matrix processing chip 220 may include multiple inter-chip links 225 (e.g., twelve inter-chip links). In some embodiments, an inter-chip link 225 may be implemented using one or more serializer / de-serializer (SerDes) interfaces. A SerDes interface may be a communication interface that converts data from serial to parallel, and vice-versa. For example, the transmitter of a SerDes interface may include a serial-to-parallel converter, and the receiver of a SerDes interface may include a parallel-to-serial converter. In some embodiments, a matrix processing chip 220 may use multiple SerDes interfaces for each connection to another matrix processing chip (e.g., four SerDes interfaces between each pair of connected matrix processing chips).

High bandwidth memory (HBM) modules 240 may be memory components associated with matrix processing chip 220 that are used to store matrix operands and other matrix data. In some embodiments, high bandwidth memory (HBM) modules 240 may be designed to efficiently store and retrieve matrix data. In some embodiments, high bandwidth memory (HBM) modules 240 may be multi-dimensional memory components configured to store and retrieve data in multiple dimensions. For example, in some embodiments, high bandwidth memory (HBM) modules 240 may be memory components configured to store and retrieve data in two dimensions, such as rows and columns. Other embodiments, however, may use memory components configured to store and retrieve data using any other number of dimensions (e.g., one dimension, three dimensions, four dimensions, and so forth). In the illustrated embodiment, matrix processing chip 220 includes four high bandwidth memory (HBM) modules 240a-d. In some embodiments, high bandwidth memory (HBM) modules 240 may be shared by the matrix processing clusters 230 of a matrix processing chip 220.

Matrix processing clusters 230 may include processing resources configured to perform matrix operations, such as matrix multiplication, convolutions, and/or dimension shuffling, among other examples. In some embodiments, matrix processing clusters 230 may be collectively used to execute a particular matrix operation by performing matrix processing in parallel. In the illustrated embodiment, matrix processing chip 220 includes twelve matrix processing clusters 230a-l. Moreover, in the illustrated embodiment, matrix processing clusters 230 are configured or arranged using a two-dimensional mesh interconnection topology. The interconnection topology of matrix processing clusters 230 may facilitate cyclical communication among the matrix processing clusters 230. Moreover, other embodiments may include any number and/or arrangement of matrix processing clusters 230.

**FIGURE 2C** illustrates a block diagram for an example embodiment of a matrix processing cluster 230. In the illustrated embodiment, matrix processing cluster 230 includes master control CPU (MCC) 232, matrix processing units (MPUs) 234, slicing engine 236, and memory resource blocks (MRBs) 238.

Master control CPU (MCC) 232 may be configured to control and/or manage matrix operations performed by a matrix processing cluster 230. In some embodiments, master control CPU 232 may be a microprocessor, an integrated circuit, and/or any other type of circuitry and/or processing logic. In some embodiments, master control CPU 232 may receive instructions from another component, such as host processor 260 of FIGURE 2A and/or controller 222 of FIGURE 2B. Based on the instructions, master control CPU 232 may then use matrix processing units 234 to perform matrix operations, such as matrix multiplication, convolutions, and/or dimension shuffling, among other examples. For example, master control CPU 232 may receive an instruction to perform a matrix multiplication operation, such as C = A * B. The instruction may include the handles or identifiers for each matrix, and may also indicate how the matrices should be stored in memory resource blocks (MRBs) 238. Matrices A and B may then be broken down into a series of smaller matrices (e.g., 32x32 matrices). Matrix operations may then be performed on the smaller matrices, and the partial results may be stored in memory resource blocks (MRBs) 238, until the output matrix C has been fully computed.

Matrix processing units (MPUs) 234 may be configured to perform matrix operations, such as matrix multiplication, convolutions, and/or dimension shuffling. In some embodiments, matrix processing units (MPUs) 234 perform matrix operations based on commands received from master control CPU (MCC) 232. Moreover, in some embodiments, each matrix processing cluster 230 may include multiple matrix processing units (MPUs) 234. For example, in the illustrated embodiment, matrix processing cluster 230 includes two matrix processing units (MPUs) 234. A matrix processing unit (MPU) 234 may be capable of performing matrix operations, such as matrix multiplication, on small matrices (e.g., 32x32 matrices). In some cases, a matrix processing unit (MPU) 234 may be designed and/or optimized to perform matrix multiplication operations. A matrix processing unit (MPU) 234 may load matrix operands from memory resource blocks (MRBs) 238. In some embodiments, a matrix processing unit (MPU) 234 may support the following arithmetic operations: matrix multiplication; unary matrix operations; binary matrix operations, such as addition (+), subtraction (-), multiplication (*), division (/), bitwise XOR, AND, OR, logical and arithmetic left and right shift, comparison (>, <, >=, <=, ==, !=); and column-wise, row-wise, and matrix-wide operations, such as sum, max value, and min value.

Slicing engine 236 may be configured to slice the matrix operands of a particular matrix operation into smaller partial matrices. For example, in some embodiments, master control CPU (MCC) 232 may use slicing engine 236 to break up matrix operands into smaller partial matrices for matrix processing units (MPUs) 234. In some embodiments, slicing engine 236 may include a convolution slicing engine (CSE) to perform matrix slicing for convolution operations. For example, in some embodiments, a convolution slicing engine (CSE) may slice matrix operands in a manner that enables a convolution operation to be cast as a matrix multiplication operation, thus enabling the same processing logic to perform both matrix multiplication and convolution operations. Moreover, in some embodiments, slicing engine 236 and/or the associated convolution slicing engine (CSE) may be used to perform the dimension shuffle operations to reorder the dimensions of a matrix.

Memory resource blocks (MRBs) 238 may be memory components on matrix processing cluster 230 used to store matrix operands and other matrix data. In some embodiments, memory resource blocks (MRBs) 238 may be designed to store and retrieve matrix data efficiently. In some embodiments, memory resource blocks (MRBs) 238 may be multi-dimensional memory components configured to store and retrieve data in multiple dimensions. For example, in some embodiments, memory resource blocks (MRBs) 238 may be memory components configured to store and retrieve data in two dimensions, such as rows and columns. In the illustrated embodiment, matrix processing cluster 230 includes ten memory resource blocks (MRBs) 238. Other embodiments, however, may include a different number of memory resource blocks (MRBs) 238 on a matrix processing cluster 230. In some embodiments, each memory resource block (MRB) 238 may be capable of storing a matrix of a certain size (e.g., a 256x512 matrix). In some embodiments, memory resource blocks (MRBs) 238 may be shared by the matrix processing units (MPUs) 234 of a particular matrix processing cluster 230.

In some embodiments, the matrix processing architecture of FIGURES 2A - 2C may be used to implement the matrix processing functionality described throughout this disclosure. For example, matrix processing system 200 may be used to perform matrix operations using a distributed approach that achieves 100% processing efficiency using the available processing resources. For example, in some embodiments, a matrix operation may be distributed across multiple processing resources 210 that are optimized for matrix processing, thus enabling full utilization of the processing resources 210 throughout the duration of the matrix operation. For example, matrix processing system 200 may include multiple processing resources 210 that are designed and optimized for performing matrix operations. In some embodiments, these processing resources 210 may be configured in a single-cyclical or dual-cyclical arrangement. In addition, the processing resources 210 may be arranged hierarchically with multiple levels of processing resources. For example, in some embodiments, the processing resources 210 may include multiple matrix processing chips 220, multiple high bandwidth memory (HBM) modules 240 and multiple matrix processing clusters 230 on each matrix processing chip 220, and/or multiple matrix processing units (MPUs) 234 on each matrix processing cluster 230. This processing architecture enables matrix operations to be distributed across multiple processing resources 210 and/or processing hierarchies with 100% processing efficiency. In addition, this processing architecture enables matrix operations to be efficiently scaled across a variable number of processing resources 210 operating in parallel, while still achieving 100% processing efficiency. For example, scaling may be achieved by adjusting the number of processing resources 210 used to perform a particular matrix operation, such as the number of matrix processing systems 200 or servers, the number of matrix processing chips 220 in each matrix processing system 200 or server, and so forth.

As an example, the matrix processing architecture of FIGURES 2A - 2C may be used to implement matrix multiplication and/or convolution operations. For example, in some embodiments, a matrix multiplication operation may be distributed across multiple processing resources 210 in a manner that results in the latency for communicating matrix operands being less than the matrix processing time, which allows the communication of matrix operands to be completed while the matrix processing is being performed. For example, for certain matrix operations involving matrix operands with certain dimensions (e.g., matrix multiplication with a "thin" matrix operand), the time required to access and communicate matrix operands may exceed the time required to perform the actual matrix computations, resulting in idle processing time while the matrix operands are being obtained from memory and/or communicated to processing resources 210. For example, a single-cyclical configuration (e.g., where each processing resource 210 only obtains matrix operands and data from one neighboring processing resource 210 at any given time) may be unable to achieve 100% processing efficiency for these particular types of matrix operations and matrix operands. However, a dual-cyclical configuration of processing resources 210 enables each processing resource to perform matrix computations while simultaneously obtaining matrix operands and data from *both* of its neighboring processing resources 210, which significantly reduces the latency for communicating matrix operands, and thus avoids any idle processing time. For example, the communication latency for certain operations may be reduced by half when using a dual-cyclical approach as opposed to a single-cyclical approach. In this manner, the latency for communicating matrix operands and matrix data can be fully masked by the matrix processing time, thus avoiding any wasted or idle processing time and achieving 100% processing efficiency. Accordingly, matrix operations (e.g., matrix multiplication or GEMM) can be performed efficiently even for large matrix operands and/or matrix operands with certain dimensions, such as a large matrix operand that is neither square nor a single vector (e.g., a "thin" matrix with a much larger height than width). For example, matrix multiplication can be performed efficiently even when multiplying two thin matrices, a thin matrix and a square matrix, and so forth. Similarly, convolution operations may be distributed across multiple processing resources 210 in a manner that results in 100% processing efficiency using the available processing resources.

As an example, when a matrix operation or command is received, the matrix operation may be distributed across the processing resources 210 of matrix processing system 200. For example, the matrix operands (or input matrices) may be partitioned based on the number of available processing resources 210. Moreover, in some embodiments, the partitions may be across the rows of the matrix operands, and/or across any other dimension of the matrix operands. Each partition may then be distributed to a particular processing resource 210. Each processing resource 210 may then perform a plurality of partial matrix operations. In some embodiments, the plurality of partial matrix operations is performed in a plurality of stages. For example, each processing resource 210 may perform a particular stage of partial matrix operations while simultaneously sending and receiving partial matrix data to and from its neighboring processing resources 210. For example, in a single-cyclical configuration of processing resources 210, each processing resource 210 either sends or receives partial matrix data to or from each neighbor processing resource. Similarly, in a dual-cyclical configuration of processing resources 210, each processing resource 210 may send and receive partial matrix data to and from each neighboring processing resource 210.

Each processing resource 210 may then use the partial matrix data for subsequent partial matrix operations. The result of the matrix operation may then be determined based on the partial matrix operations collectively performed by the processing resources 210.

Moreover, if the processing resources 210 are arranged hierarchically, the matrix operation may be distributed in a hierarchical manner. For example, the matrix operands (or input matrices) may initially be partitioned based on the number of available matrix processing chips 220. Each partition, and the associated partial matrix operations, may then be distributed to a particular matrix processing chip 220. The partition and partial matrix operations distributed to a particular matrix processing chip 220 may then be similarly partitioned and distributed across the matrix processing clusters 230 and/or high bandwidth memory (HBM) modules 240 of the particular matrix processing chip 220. For example, for certain matrix operations, partial matrix operations may be distributed to each matrix processing cluster 230. Alternatively, for certain matrix operations, partial matrix operations may be distributed across various "logical processing nodes" (e.g., groups of matrix processing clusters 230 associated with a high-bandwidth memory (HBM) module 240), and may then be distributed to each matrix processing cluster 230 of a particular logical processing node. In some embodiments, the matrix processing clusters 230 (and/or the logical processing nodes) may be cyclically configured similar to the matrix processing chips 220. The partition and partial matrix operations distributed to a particular matrix processing cluster 230 may then be similarly partitioned and distributed across the matrix processing units (MPUs) 234 of the particular matrix processing cluster 230.

### Example Computer Processor Architectures

**FIGURES 3** **and** **4** illustrate block diagrams for example embodiments of computer processors that may be used in accordance with embodiments disclosed herein. For example, the computer processors illustrated in FIGURES 3 and 4 may be used as host processors associated with matrix processing systems (e.g., host processor 260 in matrix processing system 200 of FIGURE 2A), or as processors associated with other components and/or devices discussed throughout this disclosure (e.g., processors associated with components in system 100 of FIGURE 1). Other processor and system designs and configurations known in the art for laptops, desktops, handheld PCs, personal digital assistants, engineering workstations, servers, network devices, network hubs, switches, embedded processors, digital signal processors (DSPs), graphics devices, video game devices, set-top boxes, micro controllers, cell phones, portable media players, hand held devices, and various other electronic devices, are also suitable. In general, a huge variety of systems or electronic devices capable of incorporating a processor and/or other execution logic as disclosed herein are generally suitable.

**FIGURE 3** illustrates a block diagram for an example embodiment of a processor 300. Processor 300 is an example of a type of hardware device that can be used in connection with the embodiments described throughout this disclosure. Processor 300 may be any type of processor, such as a microprocessor, an embedded processor, a digital signal processor (DSP), a network processor, a multi-core processor, a single core processor, or other device to execute code. Although only one processor 300 is illustrated in FIGURE 3, a processing element may alternatively include more than one of processor 300 illustrated in FIGURE 3. Processor 300 may be a single-threaded core or, for at least one embodiment, the processor 300 may be multi-threaded in that it may include more than one hardware thread context (or "logical processor") per core.

FIGURE 3 also illustrates a memory 302 coupled to processor 300 in accordance with an embodiment. Memory 302 may be any of a wide variety of memories (including various layers of memory hierarchy) as are known or otherwise available to those of skill in the art. Such memory elements can include, but are not limited to, random access memory (RAM), read only memory (ROM), logic blocks of a field programmable gate array (FPGA), erasable programmable read only memory (EPROM), and electrically erasable programmable ROM (EEPROM).

Processor 300 can execute any type of instructions associated with algorithms, processes, or operations detailed herein. Generally, processor 300 can transform an element or an article (e.g., data) from one state or thing to another state or thing.

Code 304, which may be one or more instructions to be executed by processor 300, may be stored in memory 302, or may be stored in software, hardware, firmware, or any suitable combination thereof, or in any other internal or external component, device, element, or object where appropriate and based on particular needs. In one example, processor 300 can follow a program sequence of instructions indicated by code 304. Each instruction enters a front-end logic 306 and is processed by one or more decoders 308. The decoder may generate, as its output, a micro operation such as a fixed width micro operation in a predefined format, or may generate other instructions, microinstructions, or control signals that reflect the original code instruction. Front-end logic 306 may also include register renaming logic and scheduling logic, which generally allocate resources and queue the operation corresponding to the instruction for execution.

Processor 300 can also include execution logic 314 having a set of execution units 316a, 316b, 316n, etc. Some embodiments may include a number of execution units dedicated to specific functions or sets of functions. Other embodiments may include only one execution unit or one execution unit that can perform a particular function. Execution logic 314 performs the operations specified by code instructions.

After completion of execution of the operations specified by the code instructions, back-end logic 318 can retire the instructions of code 304. In one embodiment, processor 300 allows out of order execution but requires in order retirement of instructions. Retirement logic 320 may take a variety of known forms (e.g., re-order buffers or the like). In this manner, processor 300 is transformed during execution of code 304, at least in terms of the output generated by the decoder, hardware registers and tables utilized by register renaming logic 310, and any registers (not shown) modified by execution logic 314.

Although not shown in FIGURE 3, a processing element may include other elements on a chip with processor 300. For example, a processing element may include memory control logic along with processor 300. The processing element may include I/O control logic and/or may include I/O control logic integrated with memory control logic. The processing element may also include one or more caches. In some embodiments, non-volatile memory (such as flash memory or fuses) may also be included on the chip with processor 300.

**FIGURE 4** illustrates a block diagram for an example embodiment of a multiprocessor 400. As shown in FIGURE 4, multiprocessor system 400 is a point-to-point interconnect system, and includes a first processor 470 and a second processor 480 coupled via a point-to-point interconnect 450. In some embodiments, each of processors 470 and 480 may be some version of processor 300 of FIGURE 3.

Processors 470 and 480 are shown including integrated memory controller (IMC) units 472 and 482, respectively. Processor 470 also includes as part of its bus controller units point-to-point (P-P) interfaces 476 and 478; similarly, second processor 480 includes P-P interfaces 486 and 488. Processors 470, 480 may exchange information via a point-to-point (P-P) interface 450 using P-P interface circuits 478, 488. As shown in FIGURE 4, IMCs 472 and 482 couple the processors to respective memories, namely a memory 432 and a memory 434, which may be portions of main memory locally attached to the respective processors.

Processors 470, 480 may each exchange information with a chipset 490 via individual P-P interfaces 452, 454 using point to point interface circuits 476, 494, 486, 498. Chipset 490 may optionally exchange information with the coprocessor 438 via a high-performance interface 439. In one embodiment, the coprocessor 438 is a special-purpose processor, such as, for example, a high-throughput MIC processor, a network or communication processor, compression engine, graphics processor, GPGPU, embedded processor, matrix processor, or the like.

A shared cache (not shown) may be included in either processor or outside of both processors, yet connected with the processors via P-P interconnect, such that either or both processors' local cache information may be stored in the shared cache if a processor is placed into a low power mode.

Chipset 490 may be coupled to a first bus 416 via an interface 496. In one embodiment, first bus 416 may be a Peripheral Component Interconnect (PCI) bus, or a bus such as a PCI Express bus or another third generation I/O interconnect bus, although the scope of this disclosure is not so limited.

As shown in FIGURE 4, various I/O devices 414 may be coupled to first bus 416, along with a bus bridge 418 which couples first bus 416 to a second bus 420. In one embodiment, one or more additional processor(s) 415, such as coprocessors, high-throughput MIC processors, GPGPU's, accelerators (such as, e.g., graphics accelerators or digital signal processing (DSP) units), matrix processors, field programmable gate arrays, or any other processor, are coupled to first bus 416. In one embodiment, second bus 420 may be a low pin count (LPC) bus. Various devices may be coupled to a second bus 420 including, for example, a keyboard and/or mouse 422, communication devices 427 and a storage unit 428 such as a disk drive or other mass storage device which may include instructions/code and data 430, in one embodiment. Further, an audio I/O 424 may be coupled to the second bus 420. Note that other architectures are possible. For example, instead of the point-to-point architecture of FIGURE 4, a system may implement a multi-drop bus or other such architecture.

All or part of any component of FIGURE 4 may be implemented as a separate or stand-alone component or chip, or may be integrated with other components or chips, such as a system-on-a-chip (SoC) that integrates various computer components into a single chip.

Embodiments of the mechanisms disclosed herein may be implemented in hardware, software, firmware, or a combination of such implementation approaches. Certain embodiments may be implemented as computer programs or program code executing on programmable systems comprising at least one processor, a storage system (including volatile and non-volatile memory and/or storage elements), at least one input device, and at least one output device.

Program code, such as code 430 illustrated in FIGURE 4, may be applied to input instructions to perform the functions described herein and generate output information. The output information may be applied to one or more output devices, in known fashion. For purposes of this application, a processing system includes any system that has a processor, such as, for example; a digital signal processor (DSP), a microcontroller, an application specific integrated circuit (ASIC), or a microprocessor.

The program code may be implemented in a high level procedural or object oriented programming language to communicate with a processing system. The program code may also be implemented in assembly or machine language, if desired. In fact, the mechanisms described herein are not limited in scope to any particular programming language. In any case, the language may be a compiled or interpreted language.

One or more aspects of at least one embodiment may be implemented by representative instructions stored on a machine-readable medium which represents various logic within the processor, which when read by a machine causes the machine to fabricate logic to perform the techniques described herein. Such representations, known as "IP cores" may be stored on a tangible, machine readable medium and supplied to various customers or manufacturing facilities to load into the fabrication machines that actually make the logic or processor.

Such machine-readable storage media may include, without limitation, non-transitory, tangible arrangements of articles manufactured or formed by a machine or device, including storage media such as hard disks, any other type of disk including floppy disks, optical disks, compact disk read-only memories (CD-ROMs), compact disk rewritable's (CD-RWs), and magneto-optical disks, semiconductor devices such as read-only memories (ROMs), random access memories (RAMs) such as dynamic random access memories (DRAMs), static random access memories (SRAMs), erasable programmable read-only memories (EPROMs), flash memories, electrically erasable programmable read-only memories (EEPROMs), phase change memory (PCM), magnetic or optical cards, or any other type of media suitable for storing electronic instructions.

Accordingly, embodiments of this disclosure also include non-transitory, tangible machine-readable media containing instructions or containing design data, such as Hardware Description Language (HDL), which defines structures, circuits, apparatuses, processors and/or system features described herein. Such embodiments may also be referred to as program products.

### Matrix Storage Using Data Shifting Memory

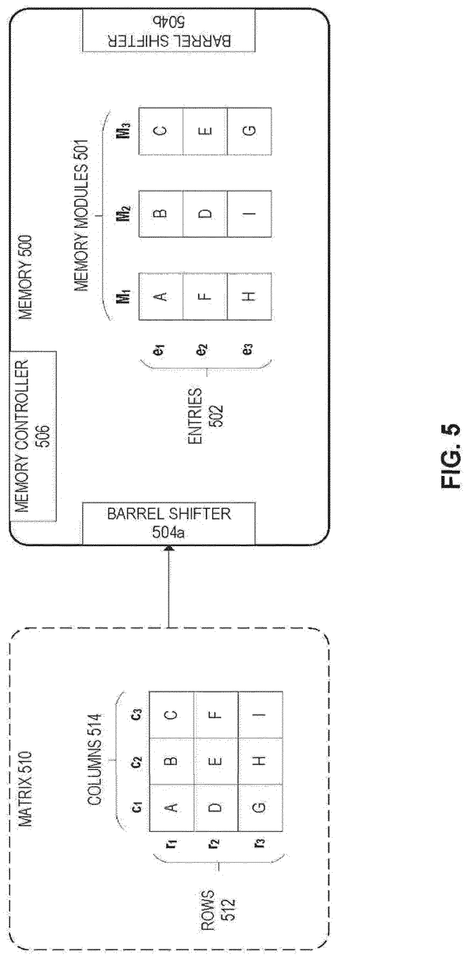

**FIGURE 5** illustrates an example embodiment of memory 500 for storing matrices using data shifting. In some embodiments, for example, memory 500 may be used to provide efficient storage of matrices in a matrix processing system, such as matrix processing system 200 of FIGURES 2A - 2C. For example, memory 500 could be used to implement the memory resource blocks (MRBs) 238 of matrix processing cluster 230 from FIGURE 2C.

Matrices can be stored in memory using a variety of approaches. Some approaches for storing matrices are inefficient, however, as they are unable to efficiently access both rows and columns of a matrix. For example, some approaches are unable to access particular rows and columns of a matrix in their entirety, instead requiring each element of a particular row or column to be accessed individually (e.g., by accessing each element in separate clock cycles). Moreover, some approaches are only able to access either the rows of a matrix or the columns of a matrix in their entirety, but not both. For example, some approaches can access particular rows of a matrix in their entirety, while particular columns can only be accessed by separately accessing each element. Similarly, some approaches can access particular columns of a matrix in their entirety, while particular rows can only be accessed by separately accessing each element. Accordingly, these matrix storage approaches are inefficient for matrix operations that involve access to entire rows and columns of a matrix. For example, a transpose operation is a common operation used in many complex matrix algorithms. A transpose operation, for example, is used to "transpose" the rows and columns of a matrix, by rearranging the rows as columns and the columns as rows. A transpose operation can be performed on a matrix processor, for example, by retrieving each row of a matrix from memory, and then storing each row back in memory as a column. Accordingly, a transpose operation may be very inefficient if the underlying memory is unable to store and retrieve rows and columns of a matrix in their entirety, as it may involve a significant number of memory accesses.

The matrix memory and storage embodiments described throughout this disclosure, however, provide an efficient approach for accessing both rows and columns of a matrix stored in memory. For example, in the illustrated embodiment, memory 500 may be used to store or retrieve an entire row or column of a matrix in a single clock cycle. For example, memory 500 can be implemented using M separate memory modules 501 that are each N entries 502 deep, thus providing storage capacity for matrix data of size N x M. Moreover, each memory module 501 may have read and write ports for reading or writing a particular entry 502 every clock cycle. In some embodiments, memory 500 may store a particular matrix by spreading or shifting the elements of each particular row and column across the M separate memory modules 501, as described further below. In this manner, each element of a particular row or column of a matrix is stored in a different memory module 501 of memory 500. Accordingly, memory 500 can access a particular row or column of the matrix in its entirety by accessing the appropriate entry 502 of each of the M separate memory modules 501. In this manner, an entire row or column of a matrix stored in memory 500 can be accessed in a single clock cycle.

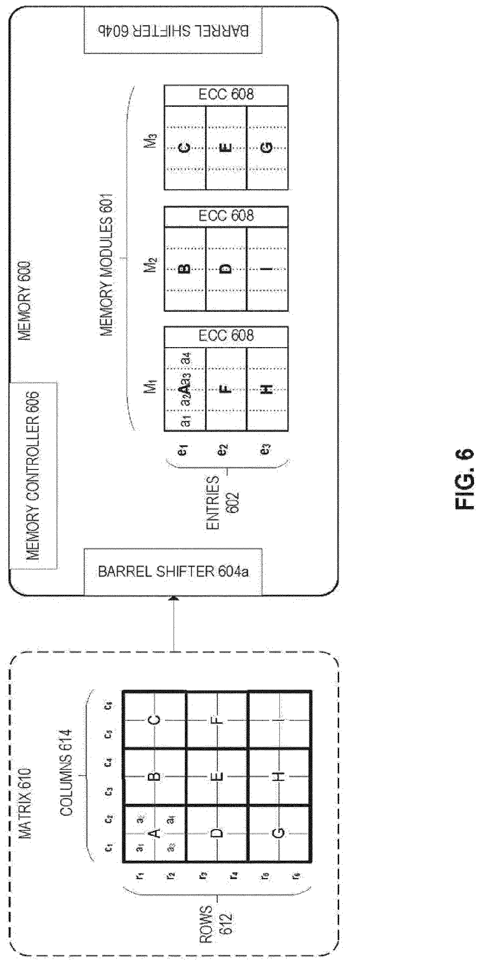

In the illustrated embodiment, for example, memory 500 includes a plurality of memory modules 501, and each memory module 501 includes a plurality of entries 502. For example, memory 500 includes three memory modules 501 (M₁, M₂, and M₃), and each memory module 501 includes three entries 502 (e₁, e₂, and e₃). Each entry 502 may be used to store a single matrix element using a particular number of bits (e.g., 8 bits or 16 bits). Accordingly, in the illustrated embodiment, memory 500 can be used to store a 3x3 matrix, such as matrix 510. The illustrated embodiment, however, is merely used for illustrative purposes. In actual implementations and embodiments, memory 500 may include any number of memory modules 501, and each memory module 501 may include any number of entries 502. Moreover, each entry 502 may be any size or number of bits, and/or may be used to store multiple matrix elements rather than a single element (e.g., as described in connection with memory 600 of FIGURE 6).

Memory 500 also includes a memory controller 506. Memory controller 506 may be used for efficiently storing and retrieving rows and columns of a matrix from memory modules 501, as described further below. Moreover, in the illustrated embodiment, memory 500 includes barrel shifters 504a and 504b. Barrel shifters 504 may be used for shifting matrix data in order to provide efficient access to rows and columns of a matrix, as described further below.

In the illustrated example of FIGURE 5, memory 500 is used to store matrix 510. Matrix 510 includes a plurality of matrix elements A - I arranged into rows 512 and columns 514. For example, matrix 510 includes three rows 512 (r₁, r₂, and r₃) and three columns 514 (c₁, c₂, and c₃) for storing matrix elements A - I. Matrix 510 may be stored in memory 500 using memory modules 501. For example, each element A - I of matrix 510 may be stored in a particular entry 502 of memory modules 501.

In some embodiments, memory controller 506 may be used to efficiently store and retrieve the elements of matrix 510 in memory 500. For example, memory controller 506 may store matrix 510 by spreading or shifting the elements of each row 512 and column 514 across the memory modules 501, such that each element of a particular row 512 or column 514 is stored in a different memory module 501. Moreover, memory controller 506 is able to read and/or write a particular entry 502 in each memory module 501 every clock cycle. Accordingly, memory controller 506 can access a particular row 512 or column 514 of matrix 510 in its entirety, by accessing the appropriate entry 502 of each memory module 501 during a given clock cycle. In this manner, entire rows 512 and columns 514 can be accessed in a single clock cycle.

A row 512 of matrix 510, for example, may be written to memory 500 by storing each element of the row in a different memory module 501 of memory 500, but at the same entry 502 or offset within the memory modules 501. For example, elements A, B, C in row r₁ of matrix 510 may each be stored in entry e₁ of a particular memory module 501. Similarly, elements D, E, F in row r₂ of matrix 510 may each be stored in entry e₂ of a particular memory module 501. Finally, elements G, H, I in row r₃ of matrix 510 may each be stored in entry e₃ of a particular memory module 501. In this manner, the elements of any given row 512 of matrix 510 are stored on different memory modules 501 of memory 500.

A column 514 of matrix 510 is written to memory 500 using a similar approach as described above for rows, with the exception that each element of a column is stored at a different entry 502 or offset within the memory modules 501. For example, elements A, D, G in column c₁ of matrix 510 are respectively stored at entries e₁, e₂, and e₃ of particular memory modules 501. Similarly, elements B, E, H in column c₂ are respectively stored at entries e₁, e₂, and e₃ of particular memory modules 501. Finally, elements C, F, I in column c₃ are respectively stored at entries e₁, e₂, and e₃ of particular memory modules 501.

Moreover, the elements of a particular row 512 or column 514 may be shifted before they are written on the respective memory modules 501 of memory 500. In some embodiments, for example, a barrel shifter 504a may be used to shift the row or column elements before they are written to the respective memory modules 501 of memory 500. The shifting may be performed so that, when matrix 510 has been written to memory 500, the elements of any given column 514 of matrix 510 ultimately reside on different memory modules 501 of memory 500. The number of shifts performed when writing a particular row 512 or column 514 to memory 500 varies based on the corresponding row or column number. For example, the number of shifts performed for a particular row or column may be one less than its corresponding row or column number (e.g., # of shifts = row number - 1, or # of shifts = column number - 1).

Accordingly, when writing the rows 512 of matrix 510 to memory 500, the first row is shifted by 0 elements (e.g., no shifting is performed), the second row is shifted by +1 element, the third row is shifted by +2 elements, and so forth. For example, in the illustrated example, the elements of row r₁ are in the order A, B, C in matrix 510, and since 0 shifts are performed on row r₁, its elements are written to the respective memory modules M₁, M₂, and M₃ in their original order A, B, C. The elements of row r₂ are in the order D, E, F in matrix 510, and since +1 shift is performed on row r₂, its elements are written to the respective memory modules M₁, M₂, and M₃ in the order F, D, E. The elements of row r₃ are in the order G, H, I in matrix 510, and since +2 shifts are performed on row r₃, its elements are written to the respective memory modules M₁, M₂, and M₃ in the order H, I, G.

Similarly, when writing the columns 514 of matrix 510 to memory 500, the first column is shifted by 0 elements (e.g., no shifting is performed), the second column is shifted by +1 element, the third column is shifted by +2 elements, and so forth. For example, in the illustrated example, the elements of column c₁ are in the order A, D, G in matrix 510, and since 0 shifts are performed on column c₁, its elements are written to the respective memory modules M₁, M₂, and M₃ in their original order A, D, G. The elements of column c₂ are in the order B, E, H in matrix 510, and since +1 shift is performed on column c₂, its elements are written to the respective memory modules M₁, M₂, and M₃ in the order H, B, E. The elements of column c₃ are in the order C, F, I in matrix 510, and since +2 shifts are performed on column c₃, its elements are written to the respective memory modules M₁, M₂, and M₃ in the order F, I, C.

In order to read a row 512 or column 514 of matrix 510 from memory 500, a particular entry 502 or offset is read from each memory module M₁, M₂, and M₃. For example, in order to read a particular row 512 of matrix 510 from memory 500, the same entry 502 or offset is read from each memory module M₁, M₂, and M₃. For example, row r₁ can be retrieved by reading entry e₁ from each memory module 501, row r₂ can be retrieved by reading entry e₂ from each memory module 501, and row r₃ can be retrieved by reading entry e₃ from each memory module 501. In order to read a particular column 514 of matrix 510 from memory 500, a different entry 502 or offset is read from each memory module M₁, M₂, and M₃. For example, column c₁ can be retrieved by reading each memory module M₁, M₂, M₃ at entries e₁, e₂, and e₃, respectively. Similarly, column c₂ can be retrieved by reading each memory module M₁, M₂, M₃ at entries e₃, e₁, and e₂, respectively. Similarly, column c₃ can be retrieved by reading each memory module M₁, M₂, M₃ at entries e₂, e₃, and e₁, respectively.

After a particular row 512 or column 514 of matrix 510 is read from memory modules M₁, M₂, and M₃, the elements are out-of-order and thus must be shifted back to their original order, which is performed by barrel shifter 504b. The shifting required when reading a particular row 512 or column 514 is simply the opposite of the shifting performed when the row 512 or column 514 was originally written. Accordingly, when reading out the rows 512 of matrix 510 from memory 500, the first row is shifted by 0 elements (e.g., no shifting is performed), the second row is shifted by -1 element, the third row is shifted by - 2 elements, and so forth. Similarly, when reading out the columns 514 of matrix 510 from memory 500, the first column is shifted by 0 elements (e.g., no shifting is performed), the second column is shifted by -1 element, the third column is shifted by -2 elements, and so forth.

In this manner, when memory 500 is used to store matrix 510, the elements of any given row 512 or column 514 of matrix 510 will each reside on a different memory module 501 of memory 500. Given that memory controller 506 can access one entry 502 from each memory module 501 during a given clock cycle, storing the elements of matrix 510 in this manner allows an entire row 512 or entire column 514 of matrix 510 to be read or written during a given clock cycle. Accordingly, memory 500 can significantly improve the performance of matrix processing systems, particularly for operations that involve access to entire rows and columns of a matrix, such as transpose operations.

**FIGURE 6** illustrates another example embodiment of memory 600 for storing matrices using data shifting. In some embodiments, for example, memory 600 may be used to provide efficient storage of matrices in a matrix processing system, such as matrix processing system 200 of FIGURES 2A - 2C. For example, memory 600 could be used to implement the memory resource blocks (MRBs) 238 of matrix processing cluster 230 from FIGURE 2C.

In the illustrated embodiment, memory 600 may be similar to memory 500 of FIGURE 5. For example, memory 600 similarly includes a plurality of memory modules 601, and each memory module 601 includes a plurality of entries 602. For example, memory 600 includes three memory modules 601 (M₁, M₂, and M₃), and each memory module 601 includes three entries 602 (e₁, e₂, and e₃). Memory 600 also includes a memory controller 606 for efficiently storing and retrieving rows and columns of a matrix from memory modules 601. Moreover, memory 600 includes barrel shifters 604a and 604b for shifting matrix data stored in memory 600.

However, in the illustrated embodiment of memory 600, each entry 602 of memory modules 601 can store up to four matrix elements using a particular number of bits, such as 64 bits. Moreover, each entry 602 also includes a particular number of bits for storing error correction codes (ECC) 608, such as 8 bits. Error correction codes, for example, can be used to correct errors in the data stored and retrieved using entries 602 of memory modules 601. For example, in some cases, an error correction code for a particular entry 602 may be able to correct single bit errors and may be able to detect double bit errors. Accordingly, each entry 602 includes 64 bits for storing up to four matrix elements, plus an additional 8 bits for storing an error correction code 608, totaling 72 bits per entry 602. Thus, in the illustrated example, the error correction codes 608 consume approximately 10% of the storage capacity of each entry 602.

If entries are implemented using a smaller number of bits to store matrix elements (e.g., 8 bits or 16 bits to store a single matrix element), fewer bits may similarly be required for the corresponding error correction codes, but the error correction codes would consume a much larger overall percentage of each entry. For example, if each entry is implemented with 16 bits for storing a single matrix element, an additional 5 bits may be required for a corresponding error correction code, resulting in 21 bits per entry. In that example, the error correction code consumes approximately 25% of the storage capacity of a given entry. Thus, as the total storage capacity of an entry decreases, the percentage of the storage capacity consumed by an associated error correction code increases. Accordingly, entries with smaller storage capacities may be much less efficient for storing data with error correction codes than entries with larger storage capacities.

Memory 600 may be used for storing matrices in a similar manner as memory 500 of FIGURE 5. However, because the entries 602 of memory modules 601 can each store up to four matrix elements, the storage capacity of example memory 600 is four times larger than the storage capacity of memory 500. For example, in the illustrated embodiment, memory 600 can be used to store a 6x6 matrix, such as matrix 610. Memory 600, however, can store and retrieve the elements of matrix 610 in a similar manner as memory 500. For example, memory 600 may store matrix 610 by spreading or shifting the elements of each row 612 and column 614 across the memory modules 601. For example, barrel shifters 604a and 604b may be used to shift the elements of rows 612 and columns 614 when they are stored and retrieved on memory 600, similar to barrel shifters 504a and 504b of memory 500 from FIGURE 5. In this manner, when memory 600 is used to store matrix 610, the elements of any given row 612 or column 614 of matrix 610 will reside on different memory modules 601 of memory 600. Given that memory 600 can access one entry 602 from each memory module 601 during a given clock cycle, storing the elements of matrix 610 in this manner allows an entire row 612 or entire column 614 of matrix 610 to be read or written during a given clock cycle. Accordingly, memory 600 can significantly improve the performance of matrix processing systems, particularly for operations that involve access to entire rows and columns of a matrix, such as transpose operations.

Memory 600, however, arranges the elements of matrix 610 using a variation of the approach used by memory 500 for the elements of matrix 510 in FIGURE 5. For example, given that the entries 602 of memory modules 601 can each store four matrix elements, accessing a particular entry 602 of memory modules 601 involves access to four matrix elements rather than one matrix element. Accordingly, memory 600 stores and retrieves matrix elements in blocks of four. FIGURE 6 illustrates the manner in which memory 600 stores or arranges the elements of matrix 610 in memory modules 601. For example, matrix 610 is logically partitioned into 2x2 blocks of matrix elements, and each 2x2 block is stored in a single entry 602 of memory modules 601. For example, matrix 610 is logically partitioned into blocks A - I, which are 2x2 blocks of matrix elements in matrix 610, and each block A - I is stored in a single entry 602 of memory modules 601. For example, memory 600 stores and retrieves these respective blocks A - I of matrix 610 using the same approach as used by memory 500 for the respective elements A - I of matrix 510 from FIGURE 5. Thus, memory 600 uses the same storage approach as memory 500, but memory 600 operates on blocks of four matrix elements while memory 500 operates on single matrix elements.

The illustrated embodiment of memory 600 is merely used for illustrative purposes. In actual implementations and embodiments, memory 600 may include any number of memory modules 601, and each memory module 601 may include any number of entries 602. Moreover, each entry 602 may be any size or number of bits for storing any number of matrix elements.

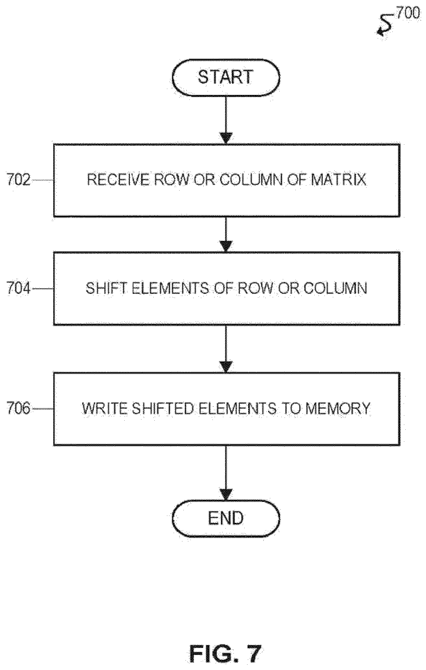

**FIGURE 7** illustrates a flowchart 700 for an example embodiment of matrix storage using data shifting memory. Flowchart 700 may be implemented, in some embodiments, by components described throughout this disclosure (e.g., memory 500 of FIGURE 5, memory 600 of FIGURE 6, and/or components of matrix processing system 200 of FIGURES 2A-C).

The flowchart may begin at block 702 by receiving a row or column of a matrix to write to memory. In some embodiments, for example, the memory (or an associated memory controller) may receive a command to store a particular row or column of a matrix, and thus the corresponding elements of the particular row or column may be provided or otherwise identified to the memory.

In some embodiments, the memory may be implemented using M separate memory modules that are each N entries deep. Moreover, each entry may be able to store a single matrix element using a particular number of bits, such as 8 or 16 bits. Accordingly, the memory may provide storage capacity for matrix data of size N * M (e.g., N rows of matrix elements and M columns of matrix elements). Moreover, each memory module may include read and write ports for reading or writing a particular entry of the memory module every clock cycle.

Alternatively, in some embodiments, each entry N of the M memory modules may be able to store four matrix elements using a particular number of bits, such as 64 bits. Accordingly, the memory may provide storage capacity for matrix data of size 4N * M. Moreover, each entry may also include a particular number of bits for storing error correction codes (ECC), such as 8 bits. Error correction codes, for example, can be used to correct errors in the data stored and retrieved using the entries of memory modules. For example, in some cases, an error correction code for a particular entry may be able to correct single bit errors and may be able to detect double bit errors. Accordingly, in these embodiments, each entry may include 64 bits for storing up to four matrix elements, plus an additional 8 bits for storing an error correction code, totaling 72 bits per entry. Thus, the error correction codes consume approximately 10% of the storage capacity of each entry.

The flowchart may then proceed to block 704 to shift the elements of the particular row or column that is being written to memory. In some embodiments, for example, the memory may be used to store a particular matrix by spreading or shifting the elements of each particular row and column across the M separate memory modules. The elements of a particular row or column may be shifted before they are written on the respective memory modules of the memory, for example, using a barrel shifter. The shifting may be performed so that, when the matrix has been written to the memory, the elements of any given row or column of the matrix ultimately reside on different memory modules of the memory. The number of shifts performed when writing a particular row or column to the memory varies based on the corresponding row or column number. For example, the number of shifts performed for a particular row or column may be one less than its corresponding row or column number (e.g., # of shifts = row number - 1, or # of shifts = column number - 1). Accordingly, when writing a row of a matrix to memory, the first row is shifted by 0 elements (e.g., no shifting is performed), the second row is shifted by +1 element, the third row is shifted by +2 elements, and so forth. Similarly, when writing a column of a matrix to memory, the first column is shifted by 0 elements (e.g., no shifting is performed), the second column is shifted by +1 element, the third column is shifted by +2 elements, and so forth.

The flowchart may then proceed to block 706 to write the shifted elements to memory. The shifted elements of the particular row or column may be written to the respective memory modules of the memory in their respective order after the shifting is performed. Moreover, when writing a row of a matrix to memory, each element of the row is written at the same entry or offset within the memory modules. However, when writing a column of a matrix to memory, each element of the column is written at a different entry or offset within the memory modules.

In order to read a row or column of the matrix from memory, a particular entry or offset is read from each memory module. For example, in order to read a particular row of the matrix from memory, the same entry or offset is read from each memory module. In order to read a particular column of a matrix from memory, a different entry or offset is read from each memory module. After a particular row or column of the matrix is read from the memory modules, however, the elements are out-of-order and thus must be shifted back to their original order, which can be performed by a barrel shifter. The shifting required when reading a particular row or column is simply the opposite of the shifting performed when the row or column was originally written. Accordingly, when reading out the rows of a matrix from memory, the first row is shifted by 0 elements (e.g., no shifting is performed), the second row is shifted by -1 element, the third row is shifted by -2 elements, and so forth. Similarly, when reading out the columns of a matrix from memory, the first column is shifted by 0 elements (e.g., no shifting is performed), the second column is shifted by -1 element, the third column is shifted by -2 elements, and so forth.

In this manner, when the memory is used to store a matrix, the elements of any given row or column of the matrix will reside on different memory modules of the memory. Given that the memory can access one entry from each memory module during a given clock cycle, storing the elements of the matrix in this manner allows an entire row or entire column of the matrix to be read or written during a given clock cycle. Accordingly, the memory can be used to significantly improve the performance of matrix processing systems, particularly for operations that involve access to entire rows and columns of a matrix, such as transpose operations.

At this point, the flowchart may be complete. In some embodiments, however, the flowchart may restart and/or certain blocks may be repeated. For example, in some embodiments, the flowchart may restart at block 702 to continue writing rows and columns of a matrix to memory.

The flowcharts and block diagrams in the FIGURES illustrate the architecture, functionality, and operation of possible implementations of systems, methods and computer program products according to various aspects of the present disclosure. In this regard, each block in the flowchart or block diagrams may represent a module, segment, or portion of code, which comprises one or more executable instructions for implementing the specified logical function(s). It should also be noted that, in some alternative implementations, the functions noted in the block may occur out of the order noted in the figures. For example, two blocks shown in succession may, in fact, be executed substantially concurrently, or the blocks may sometimes be executed in the reverse order or alternative orders, depending upon the functionality involved. It will also be noted that each block of the block diagrams and/or flowchart illustration, and combinations of blocks in the block diagrams and/or flowchart illustration, can be implemented by special purpose hardware-based systems that perform the specified functions or acts, or combinations of special purpose hardware and computer instructions.

The foregoing disclosure outlines features of several embodiments so that those skilled in the art may better understand various aspects of the present disclosure. Those skilled in the art should appreciate that they may readily use the present disclosure as a basis for designing or modifying other processes and structures for carrying out the same purposes and/or achieving the same advantages of the embodiments introduced herein. Those skilled in the art should also realize that such equivalent constructions do not depart from the spirit and scope of the present disclosure, and that they may make various changes, substitutions, and alterations herein without departing from the spirit and scope of the present disclosure.

All or part of any hardware element disclosed herein may readily be provided in a system-on-a-chip (SoC), including a central processing unit (CPU) package. An SoC represents an integrated circuit (IC) that integrates components of a computer or other electronic system into a single chip. The SoC may contain digital, analog, mixed-signal, and radio frequency functions, all of which may be provided on a single chip substrate. Other embodiments may include a multi-chip-module (MCM), with a plurality of chips located within a single electronic package and configured to interact closely with each other through the electronic package. In various other embodiments, the computing functionalities disclosed herein may be implemented in one or more silicon cores in Application Specific Integrated Circuits (ASICs), Field Programmable Gate Arrays (FPGAs), and other semiconductor chips.

As used throughout this specification, the term "processor" or "microprocessor" should be understood to include not only a traditional microprocessor (such as Intel's® industry-leading x86 and x64 architectures), but also matrix processors, graphics processors, and any ASIC, FPGA, microcontroller, digital signal processor (DSP), programmable logic device, programmable logic array (PLA), microcode, instruction set, emulated or virtual machine processor, or any similar "Turing-complete" device, combination of devices, or logic elements (hardware or software) that permit the execution of instructions.

Note also that in certain embodiments, some of the components may be omitted or consolidated. In a general sense, the arrangements depicted in the figures should be understood as logical divisions, whereas a physical architecture may include various permutations, combinations, and/or hybrids of these elements. It is imperative to note that countless possible design configurations can be used to achieve the operational objectives outlined herein. Accordingly, the associated infrastructure has a myriad of substitute arrangements, design choices, device possibilities, hardware configurations, software implementations, and equipment options.

In a general sense, any suitably-configured processor can execute instructions associated with data or microcode to achieve the operations detailed herein. Any processor disclosed herein could transform an element or an article (for example, data) from one state or thing to another state or thing. In another example, some activities outlined herein may be implemented with fixed logic or programmable logic (for example, software and/or computer instructions executed by a processor) and the elements identified herein could be some type of a programmable processor, programmable digital logic (for example, a field programmable gate array (FPGA), an erasable programmable read only memory (EPROM), an electrically erasable programmable read only memory (EEPROM)), an ASIC that includes digital logic, software, code, electronic instructions, flash memory, optical disks, CD-ROMs, DVD ROMs, magnetic or optical cards, other types of machine-readable mediums suitable for storing electronic instructions, or any suitable combination thereof.

In operation, a storage may store information in any suitable type of tangible, non-transitory storage medium (for example, random access memory (RAM), read only memory (ROM), field programmable gate array (FPGA), erasable programmable read only memory (EPROM), electrically erasable programmable ROM (EEPROM), or microcode), software, hardware (for example, processor instructions or microcode), or in any other suitable component, device, element, or object where appropriate and based on particular needs. Furthermore, the information being tracked, sent, received, or stored in a processor could be provided in any database, register, table, cache, queue, control list, or storage structure, based on particular needs and implementations, all of which could be referenced in any suitable timeframe. Any of the memory or storage elements disclosed herein should be construed as being encompassed within the broad terms 'memory' and 'storage,' as appropriate. A non-transitory storage medium herein is expressly intended to include any non-transitory special-purpose or programmable hardware configured to provide the disclosed operations, or to cause a processor to perform the disclosed operations. A non-transitory storage medium also expressly includes a processor having stored thereon hardware-coded instructions, and optionally microcode instructions or sequences encoded in hardware, firmware, or software.

Computer program logic implementing all or part of the functionality described herein is embodied in various forms, including, but in no way limited to, hardware description language, a source code form, a computer executable form, machine instructions or microcode, programmable hardware, and various intermediate forms (for example, forms generated by an HDL processor, assembler, compiler, linker, or locator). In an example, source code includes a series of computer program instructions implemented in various programming languages, such as an object code, an assembly language, or a high-level language such as OpenCL, FORTRAN, C, C++, JAVA, or HTML for use with various operating systems or operating environments, or in hardware description languages such as Spice, Verilog, and VHDL. The source code may define and use various data structures and communication messages. The source code may be in a computer executable form (e.g., via an interpreter), or the source code may be converted (e.g., via a translator, assembler, or compiler) into a computer executable form, or converted to an intermediate form such as byte code. Where appropriate, any of the foregoing may be used to build or describe appropriate discrete or integrated circuits, whether sequential, combinatorial, state machines, or otherwise.

In one example, any number of electrical circuits of the FIGURES may be implemented on a board of an associated electronic device. The board can be a general circuit board that can hold various components of the internal electronic system of the electronic device and, further, provide connectors for other peripherals. More specifically, the board can provide the electrical connections by which the other components of the system can communicate electrically. Any suitable processor and memory can be suitably coupled to the board based on particular configuration needs, processing demands, and computing designs. Other components such as external storage, additional sensors, controllers for audio/video display, and peripheral devices may be attached to the board as plug-in cards, via cables, or integrated into the board itself. In another example, the electrical circuits of the FIGURES may be implemented as stand-alone modules (e.g., a device with associated components and circuitry configured to perform a specific application or function) or implemented as plug-in modules into application specific hardware of electronic devices.

Note that with the numerous examples provided herein, interaction may be described in terms of two, three, four, or more electrical components. However, this has been done for purposes of clarity and example only. It should be appreciated that the system can be consolidated or reconfigured in any suitable manner. Along similar design alternatives, any of the illustrated components, modules, and elements of the FIGURES may be combined in various possible configurations, all of which are within the broad scope of this specification. In certain cases, it may be easier to describe one or more of the functionalities of a given set of flows by only referencing a limited number of electrical elements. It should be appreciated that the electrical circuits of the FIGURES and its teachings are readily scalable and can accommodate a large number of components, as well as more complicated/sophisticated arrangements and configurations. Accordingly, the examples provided should not limit the scope or inhibit the broad teachings of the electrical circuits as potentially applied to a myriad of other architectures.

Numerous other changes, substitutions, variations, alterations, and modifications may be ascertained to one skilled in the art and it is intended that the present disclosure encompass all such changes, substitutions, variations, alterations, and modifications as falling within the scope of the appended claims.

### Example Implementations

The following examples pertain to embodiments described throughout this disclosure.

One or more embodiments may include an apparatus, comprising: a memory comprising a plurality of memory modules, wherein each memory module comprises a plurality of storage locations; and a memory controller to write data of a matrix to the memory; wherein the memory controller is configured to write a particular row or a particular column of the matrix to the memory by: shifting a plurality of matrix elements of the particular row or the particular column; and writing the plurality of matrix elements to the plurality of memory modules.

In one example embodiment of an apparatus, the memory controller further comprises a barrel shifter to shift the plurality of matrix elements.

In one example embodiment of an apparatus, a number of shifts performed by the memory controller is based on a row number of the particular row or a column number of the particular column.

In one example embodiment of an apparatus, the memory controller is further configured to write the plurality of matrix elements to the plurality of memory modules based on a shifted order of the plurality of matrix elements.

In one example embodiment of an apparatus, the memory controller is further configured to write each of the plurality of matrix elements to a particular memory module of the plurality of memory modules.

In one example embodiment of an apparatus, the memory controller is further configured to write the particular row of the matrix using a same storage location within each of the plurality of memory modules.

In one example embodiment of an apparatus, the memory controller is further configured to write the particular column of the matrix using a different storage location within each of the plurality of memory modules.

In one example embodiment of an apparatus, each memory module is configured to access a particular storage location during a particular clock cycle.

In one example embodiment of an apparatus, each memory module further comprises: a read port to read from a first storage location during a particular clock cycle; and a write port to write to a second storage location during the particular clock cycle.

In one example embodiment of an apparatus, the memory controller is further configured to read the particular row or the particular column of the matrix from the memory by: reading the plurality of matrix elements of the particular row or the particular column from the plurality of memory modules; and shifting the plurality of matrix elements into a correct order.

In one example embodiment of an apparatus, the memory controller is further configured to perform a transpose operation on the matrix.

In one example embodiment of an apparatus, each of the plurality of storage locations are configured to store a particular number of matrix elements.

In one example embodiment of an apparatus, each of the plurality of storage locations are further configured to store an error correction code.

One or more embodiments may include a method, comprising: writing a particular row or a particular column of a matrix to a memory, wherein writing the particular row or the particular column to the memory comprises: shifting a plurality of matrix elements of the particular row or the particular column; and writing the plurality of matrix elements to a plurality of memory modules of the memory.

In one example embodiment of a method, the plurality of matrix elements is shifted using a barrel shifter.

In one example embodiment of a method, shifting the plurality of matrix elements comprises performing a particular number of shifts based on a row number of the particular row or a column number of the particular column.

In one example embodiment of a method, the method further comprises writing the plurality of matrix elements to the plurality of memory modules based on a shifted order of the plurality of matrix elements.

In one example embodiment of a method, the method further comprises writing the particular row of the matrix using a same storage location within each of the plurality of memory modules.

In one example embodiment of a method, the method further comprises writing the particular column of the matrix using a different storage location within each of the plurality of memory modules.

In one example embodiment of a method, the method further comprises reading the particular row or the particular column of the matrix from the memory, wherein reading the particular row or the particular column from the memory comprises: reading the plurality of matrix elements of the particular row or the particular column from the plurality of memory modules; and shifting the plurality of matrix elements into a correct order.

In one example embodiment of a method, the method further comprises performing a transpose operation on the matrix.

One or more embodiments may include a system, comprising: a plurality of processing elements to perform a matrix operation, comprising: a host processor; and one or more matrix processors; a memory to store matrix data, comprising: a plurality of memory modules, wherein each memory module comprises a plurality of storage locations; and a memory controller to write a particular row or a particular column of a matrix to the memory, wherein the memory controller is configured to: shift a plurality of matrix elements of the particular row or the particular column; and write the plurality of matrix elements to the plurality of memory modules.

In one example embodiment of a system, the memory controller further comprises a barrel shifter to shift the plurality of matrix elements.

One or more embodiments may include at least one machine accessible storage medium having instructions stored thereon, the instructions, when executed on a machine, cause the machine to: write a particular row or a particular column of a matrix to a memory, wherein the instructions that cause the machine to write the particular row or the particular column to the memory cause the machine to: shift a plurality of matrix elements of the particular row or the particular column; and write the plurality of matrix elements to a plurality of memory modules of the memory.

In one example embodiment of a storage medium, the instructions further cause the machine to perform a particular number of shifts based on a row number of the particular row or a column number of the particular column.

In one example embodiment of a storage medium, the instructions that cause the machine to shift the plurality of matrix elements further cause the machine to shift the plurality of matrix elements using a barrel shifter.

In one example embodiment of a storage medium, the instructions further cause the machine to write the plurality of matrix elements to the plurality of memory modules based on a shifted order of the plurality of matrix elements.

In one example embodiment of a storage medium, the instructions further cause the machine to read the particular row or the particular column of the matrix from the memory by: reading the plurality of matrix elements of the particular row or the particular column from the plurality of memory modules; and shifting the plurality of matrix elements into a correct order.

In one example embodiment of a storage medium, the instructions further cause the machine to perform a transpose operation on the matrix.

One or more embodiments may include an apparatus comprising means to perform a method in any of the preceding examples.

One or more embodiments may include at least one machine accessible storage medium having instructions stored thereon, the instructions, when executed on a machine, cause the machine to: perform a method or realize an apparatus from any of the preceding examples.

## Claims

1. A method, comprising:
writing a particular row or a particular column of a matrix to a memory,
wherein writing the particular row or the particular column to the memory comprises:
shifting a plurality of matrix elements of the particular row or the particular column; and
writing the plurality of matrix elements to a plurality of memory modules of the memory.

2. The method of Claim 1, wherein the plurality of matrix elements is shifted using a barrel shifter.

3. The method of Claim 1, wherein shifting the plurality of matrix elements comprises performing a particular number of shifts based on a row number of the particular row or a column number of the particular column.

4. The method of Claim 1, further comprising writing the plurality of matrix elements to the plurality of memory modules based on a shifted order of the plurality of matrix elements.

5. The method of any of Claims 1-4, further comprising writing the particular row of the matrix using a same storage location within each of the plurality of memory modules.

6. The method of any of Claims 1-4, further comprising writing the particular column of the matrix using a different storage location within each of the plurality of memory modules.

7. The method of any of Claims 1-4, further comprising reading the particular row or the particular column of the matrix from the memory, wherein reading the particular row or the particular column from the memory comprises:
reading the plurality of matrix elements of the particular row or the particular column from the plurality of memory modules; and
shifting the plurality of matrix elements into a correct order.

8. The method of any of Claims 1-4, further comprising performing a transpose operation on the matrix.

9. An apparatus comprising means to perform a method as claimed in any preceding claim.

10. At least one machine accessible storage medium having instructions stored thereon, the instructions when executed on a machine, cause the machine to perform a method or realize an apparatus as claimed in any preceding claim.
